# EUROPÄISCHE PATENTSCHRIFT

(11) **EP 0 721 684 B1**
(45) Veröffentlichungstag und Bekanntmachung des Hinweises auf die Patenterteilung: **09.04.1997**
(21) Anmeldenummer: 94928264.4
(22) Anmeldetag: 20.09.1994
(51) Int. Cl.: H02H 1/00, H02H 1/04

(54) **VERFAHREN ZUM GEWINNEN EINES FEHLERKENNZEICHNUNGS-SIGNALS**
METHOD OF GENERATING A FAULT-INDICATION SIGNAL
PROCEDE PERMETTANT DE GENERER UN SIGNAL D'INDICATION D'ERREUR

(30) Priorität: 27.09.1993 DE 4333257
(43) Veröffentlichungstag der Anmeldung: 17.07.1996
(73) Patentinhaber: SIEMENS AKTIENGESELLSCHAFT, 80333 München (DE)
(72) Erfinder: DALSTEIN, Thomas,Dr., D-12099 Berlin (DE)
(86) Internationale Anmeldenummer: DE9401137
(87) Internationale Veröffentlichungsnummer: WO9509463

(56) Entgegenhaltungen:
- PROCEEDINGS OF THE 27TH INTERSOCIETY ENERGY CONVERSION ENGINEERING CONFERENCE, Bd. 1, 3. August 1992, San Diego, CA, US, Seiten 1191-1196, XP366019; S.R. FERNANDO et al.: 'High impedance fault detection using artifical neural network techniques'
- IEEE TRANSACTIONS ON POWER DELIVERY, Bd.7, Nr, 4, Oktober 1992, New York, US, Seiten 1871-1877, XP298198; A.F. SULTAN et al.: 'Detection of high impedance arcing faults using a multi-layer perception'

## Beschreibung

Die Erfindung bezieht sich auf ein Verfahren zum Gewinnen eines Fehlerkennzeichnungs-Signals bei einem Fehler in einem zu überwachenden elektrischen Energieversorgungsnetz mittels einer mehrschichtigen Neuronalnetz-Anordnung, die bei simulierten dauernden und vorübergehenden Fehlern überwacht derart angelernt ist, daß sie bei einem dauernden Fehler ein Ausgangssignal mit einem vorgegeben Wert und bei einem vorübergehenden Fehler ein Ausgangssignal mit einem anderen vorgegebenen Wert abgibt.

Ein bekanntes Verfahren dieser Art ist in der Tagungsveröffentlichung Nr. 368 der Fifth International Conference on Developments in Power System Protection, York (Großbritannien), 30. März /01. April 1993 beschrieben. Dieses bekannte Verfahren geht von der Erkenntnis aus, daß bei einem auf einen festgestellten Fehler in einem zu überwachenden Energieversorgungsnetz hin erfolgenden Schalten des zugehörigen Leistungsschalters Signale erfaßbar sind, die sich durch unterschiedliche Frequenzspektren auszeichnen. Die verschiedenen Frequenzspektren können unterschiedlichen Fehlern im zu überwachenden Energieversorgungsnetz zugeordnet werden, so daß eine Unterscheidungsmöglichkeit hinsichtlich aufgetretener Fehler dahingehend gegeben ist, ob es sich um einen dauernden oder um einen vorübergehenden Fehler zwischen einer Phase des Energieversorgungsnetzes und Erde handelt. Zur Unterscheidung der dauernden und vorübergehenden Fehler zwischen einer Phase und Erde wird das beim Schalten des Leistungsschalters erfaßbare Signal einer Fast-Fourier-Transformation unterworfen und danach die gewonnenen digitalen Werte einer Neuronalnetz-Anordnung zugeführt. Diese ist vorher durch Simulation nach dem Backpropagation-Algorithmus von Rumelhart entsprechend angelernt und erzeugt daher bei ihrem Einsatz zur Gewinnung eines Fehlerkennzeichnungs-Signals bei einem Fehler in einem elektrischen Energieversorgungsnetz an seinem Ausgang ein Signal, dessen Größe einen Rückschluß auf einen dauerhaften oder vorübergehenden Fehler zuläßt. Bei einem Ausgangssignal mit einem vorgegebenen Wert handelt es sich um einen dauernden Fehler, während bei einem Ausgangssignal mit einem anderen vorübergehenden Wert ein vorübergehender Fehler signalisiert wird. Die Unterscheidung zwischen dauernden und vorübergehenden Fehlern ist deshalb von großer Bedeutung, weil bei einem vorübergehenden Fehler nach einer gewissen Wartezeit in der Regel von den Elektrizitätsversorgungsunternehmen der Leistungsschalter wieder geschlossen werden kann, so daß dann die Energieversorgung weiterhin sichergestellt ist.

Das bekannte Verfahren ist nur zur Unterscheidung zwischen dauernden und vorübergehenden Fehlern einsetzbar, wenn es sich bei diesen Fehlern um Fehler handelt, die zwischen jeweils einer Phase des zu überwachenden Energieversorgungsnetzes und Erde auftreten. Ferner benötigt das bekannte Verfahren eine relativ lange Zeit zur Gewinnung eines Fehlerkennzeichnungs-Signals, da die beim Schalten des Leistungsschalters erfaßbaren Signale zunächst einer Fast-Fourier-Transformation unterworfen werden müssen, die für mindestens eine Periode der Spannung des Energieversorgungsnetzes durchgeführt werden muß.

Der Erfindung liegt die Aufgabe zugrunde, ein Verfahren zum Gewinnen eines Fehlerkennzeichnungs-Signals anzugeben, mit dem sich in vergleichsweise kurzer Zeit ein Fehlerkennzeichnungs-Signal gewinnen läßt, und zwar auch bei sehr unterschiedlichen Fehlerfällen im zu überwachenden elektrischen Energieversorgungsnetz.

Zur Lösung dieser Aufgabe wird bei einem Verfahren der eingangs angegebenen Art erfindungsgemäß zur Unterscheidung eines Lichtbogenkurzschlusses von einem metallischen Kurzschluß eine Neuronalnetz-Anordnung verwendet, die für jede Phase des zu überwachenden Energieversorgungsnetzes ein neuronales Netz aufweist, wobei jedes neuronale Netz ein durch Simulation der Spannungen an jeder Phase bei metallischen Kurzschlüssen unter Verwendung von sinusförmigen Spannungen und bei Lichtbogen-Kurzschlüssen unter Verwendung von sinusförmigen Spannungen mit jeweils annähernd rechteckförmiger additiver Spannung überwacht derart angelerntes Verhalten aufweist, daß bei einem Lichtbogenkurzschluß das Ausgangssignal mit dem einen vorgegebenen Wert und bei einem metallischen Kurzschluß das Ausgangssignal mit dem anderen vorgegebenen Wert auftritt; gleichzeitig werden an verschiedene Neuronen der Eingangsschicht jedes neuronalen Netzes aufeinanderfolgend abgetastete, normierte Werte der Spannungen an der jeweils zugeordneten Phase des Energieversorgungsnetzes angelegt.

Es ist zwar aus "IEEE Transactions on Power Delivery" 7 (1992) Oktober, No. 4, Seiten 1871 bis 1877 ein Verfahren zum Gewinnen eines Fehlerkennzeichnungs-Signals bei einem Fehler in einem Energieversorgungsnetz bekannt, jedoch wird bei diesem Verfahren mittels eines neuronalen Netzes nach entsprechendem Anlernen zwischen einem Hochimpedanz-Fehler und Lastfällen unterschieden. Dazu wird der Strom im Energieversorgungsnetz abgetastet und normiert, und es werden die abgetasten Werte der Eingangsschicht des neuronalen Netzes zugeführt. Bei einem Hochimpedanz-Fehler gibt das einzige Neuron der Ausgangsschicht ein Ausgangssignal mit dem Wert "1", sonst ein Ausgangssignal mit dem Wert "0" ab.

Ein wesentlicher Vorteil des erfindungsgemäßen Verfahrens besteht darin, daß mit ihm in relativ kurzer Zeit nach dem Auftreten eines Kurzschlusses ein Fehlerkennzeichnungs-Signal gewonnen werden kann, das durch seine unterschiedliche Größe die Unterscheidung eines metallischen Kurzschlusses von einem Lichtbogenkurzschluß ermöglicht. Dabei setzt die Gewinnung des Fehlerkennzeichnungs-Signals bei dem erfindungsgemäßen Verfahren bereits mit der Feststellung, daß ein Kurzschluß im zu überwachenden Energieversorgungsnetz aufgetreten ist, ein; es wird bei dem erfindungsgemäßen Verfahren also nicht erst abgewartet, bis der entsprechende Leistungsschalter seine Funktion aufnimmt. Dies ist dadurch ermöglicht, daß die Spannungen an den Phasen des Energieversorgungsnetzes bei dem erfindungsgemäßen Verfahren überwacht und direkt zur Gewinnung des Fehlerkennzeichnungs-Signals herangezogen werden. Dabei wird im Rahmen des erfindungsgemäßen Verfahrens der Umstand berücksichtigt, daß bei einem Lichtbogenkurzschluß eine in Näherung rechteckförmige, additive Spannung an der betroffenen Phase erfaßbar ist, die bei jedem Nulldurchgang des Stromes an der Phase ihre Polarität ändert. Bei einem metallischen Kurzschluß hat die erfaßbare Spannung an der Phase einen annähernd sinusförmigen Verlauf. Ein weiterer wesentlicher Vorteil des erfindungsgemäßen Verfahrens wird darin gesehen, daß mit ihm nicht nur ein Fehlerkennzeichnungs-Signal bei einpoligen Kurzschlüssen gewinnbar ist, sondern auch bei mehrpoligen Kurzschlüssen, beispielsweise zwischen zwei Phasen des zu überwachenden Energieversorgungsnetzes.

Bei dem erfindungsgemäßen Verfahren können unterschiedlich aufgebaute neuronale Netze verwendet werden. Im Hinblick auf einerseits möglichst geringen Aufwand und andererseits eine hinreichende Genauigkeit hat es sich als vorteilhaft erwiesen, wenn jeweils ein neuronales Netz verwendet wird, das eine Eingangsschicht mit 20 Neuronen, eine erste Zwischenschicht mit 15 Neuronen und eine weitere Zwischenschicht mit 10 Neuronen sowie eine Ausgangsschicht mit einem einzigen Neuron aufweist; jeweils während einer der Periodendauer der Spannungen entsprechenden Zeitdauer werden zwanzig Abtastwerte der Spannungen gewonnen werden und jeweils gleichzeitig die jeweils letzten 20 abgetasteten, normierten Werte der Spannungen an der zugeordneten Phase an die Neuronen der Eingangsschicht gelegt.

Besonders zuverlässig in der Arbeitsweise läßt sich das erfindungsgemäße Verfahren dann durchführen, wenn in einer jedem neuronalen Netz nachgeordneten Nachverarbeitungseinrichtung mit mindestens zwei Verzögerungsstufen und einem UND-Glied überprüft wird, ob das Fehlerkennzeichnungs-Signal am Ausgang des jeweiligen neuronalen Netzes insgesamt mindestens dreimal aufgetreten ist.

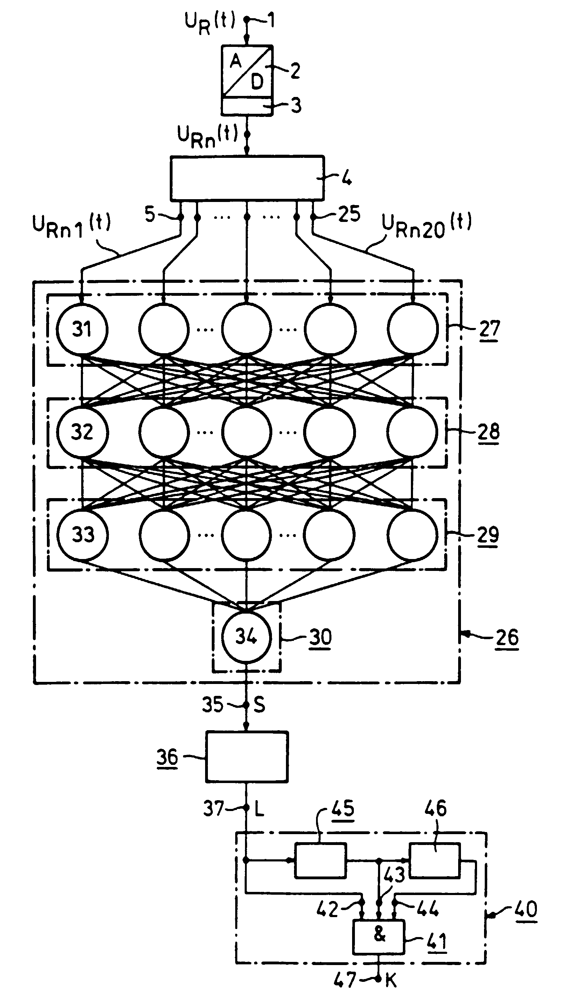

Zur Erläuterung der Erfindung ist in der Figur ein Ausführungsbeispiel einer Anordnung zur Durchführung des erfindungsgemäßen Verfahrens in bezug auf die Auswertung der Spannung an einer Phase eines zu überwachenden elektrischen Energieversorgungsnetzes dargestellt.

Der in der Figur dargestellten Anordnung werden an einem Eingang 1 abgetastete Werte U_{R}(t) zugeführt, die durch Abtastung der Spannung an der Phase R eines nicht dargestellten zu überwachenden, elektrischen Energieversorgungsnetzes gewonnen sind. Die abgetasteten Werte U_{R}(t) werden in einem eingangsseitigen Analog-Digital-Umsetzer 2 in entsprechende digitale Werte umgesetzt, die in einer nachgeordneten Normierungsstufe 3 in abgetastete, normierte Werte U_{Rn}(t) umgesetzt werden.

Die abgetasteten, normierten Werte U_{Rn}(t) werden anschließend einem Multiplexer 4 zugeführt, der zwanzig während einer der Periodendauer der Spannung an der Phase R aufeinanderfolgend abgetastete, normierte Werte über interne (in der Figur nicht dargestellte) Verzogerungsglieder auf zwanzig Ausgänge 5 bis 25 derart weiterschaltet, daß an den Ausgängen 5 bis 25 jeweils gleichzeitig die zwanzig nacheinander abgetasteten Werte U_{Rn1}(t) bis U_{Rn20}(t) anstehen. Bei einer Frequenz von 50 Hz des Energieversorgungsnetzes erfolgt die Abtastung der Spannung an der Phase R des zu überwachenden Energieversorgungsnetzes also mit einer Frequenz von 1 kHz.

Die an den Ausgängen 5 bis 25 des Multiplexers 4 anstehenden abgetasteten, normierten Werte U_{Rn1} (t) bis U_{Rn20}(t) werden eingangsseitig einem neuronalen Netz 26 zugeführt, das eine Eingangsschicht 27, eine erste Zwischenschicht 28, eine zweite Zwischenschicht 29 und eine Ausgangsschicht 30 aufweist. Die Eingangsschicht 27 ist mit zwanzig Neuronen 31 versehen, von denen in der Figur der besseren Übersichtlichkeit halber nur 5 Neuronen dargestellt sind. Jedes Neuron 31 der Eingangsschicht 27 ist mit einem der Ausgänge 5 bis 25 des Multiplexers 4 verbunden. Ausgangsseitig ist jedes Neuron 31 der Eingangsschicht 27 mit den Eingängen aller Neuronen 32 der ersten Zwischenschicht 28 verbunden, wobei in der Figur wiederum nur 5 der insgesamt 15 Neuronen der ersten Zwischenschicht 28 wegen der besseren Übersichtlichkeit dargestellt sind. Die weitere Zwischenschicht 29 des neuronalen Netzes 26 ist mit 10 Neuronen 33 besetzt, von denen ebenfalls nur 5 gezeigt sind. Alle Neuronen 33 der zweiten Zwischenschicht 29 sind mit allen Neuronen 32 der ersten Zwischenschicht verbunden. Die Ausgangsschicht 30 des neuronalen Netzes 26 enthält nur ein einziges Neuron 34, dessen Ausgang auch den Ausgang 35 des neuronalen Netzes 26 bildet.

Das neuronale Netz 26 ist durch Simulation unterschiedlicher Lichtbogenkurzschlüsse und unterschiedlicher metallischer Kurzschlüsse an einem dem zu überwachenden Energieversorgungsnetz entsprechenden Netz angelernt worden, wobei im vorliegenden Falle mit dem Netzmodell NETOMAC gearbeitet worden ist, das in der Zeitschrift "Elektrizitätswirtschaft", 1979, Heft 1, Seiten 18 bis 23 näher beschrieben ist. Dabei erfolgte das Anlernen unter Benutzung des Backpropagation-Algorithmus nach Rumelhart. Im einzelnen ist das Anlernen so vorgenommen worden, daß bei einem Lichtbogenkurzschluß am Ausgang 35 ein Fehlerkennzeichnungs-Signal S mit einem vorgegebenen Wert von 0,8 oder höher gebildet ist, während bei einem metallischen Kurzschluß ein Fehlerkennzeichnungs-Signal S mit einem anderen vorgegebenen Wert von etwa 0,1 vorliegt.

An den Ausgang 35 ist eine Schwellwerteinrichtung 36 angeschlossen, die so eingestellt ist, daß sie bei einem Fehlerkennzeichnungs-Signal mit einem Wert von 0,8 oder größer an ihrem Ausgang 37 ein Signal L abgibt, das einen Kurzschluß mit Lichtbogen kennzeichnet.

Um ein Fehlerkennzeichnungs-Signal mit besonders zuverlässiger Aussage zu erzeugen, ist an den Ausgang 37 der Schwellwerteinrichtung 36 eine Nachverarbeitungseinrichtung 40 angeschlossen, die unter anderem ein UND-Glied 41 mit drei Eingängen 42, 43 und 44 enthält. Der eine Eingang 42 des UND-Gliedes 41 ist unmittelbar mit dem Ausgang 37 der Schwellwerteinrichtung 36 verbunden, während der Eingang 43 über ein erstes Verzögerungsglied 45 an den Ausgang 37 angeschlossen ist. Dem Eingang 44 des UND-Gliedes 41 ist eine weitere Verzögerungsstufe 46 vorgeordnet, wobei diese Verzögerungsstufe 46 ebenso wie die erste Verzögerungsstufe 45 hinsichtlich der verursachten Verzögerung so bemessen ist, daß sie jeweils eine Verzögerung um einen Abtastschritt verursachen; gemeint ist hierbei die Abtastung der Spannung an der Phase R. Dies führt dazu, daß am Ausgang 47 der Nachverarbeitungseinrichtung 40 ein einen Lichtbogenkurzschluß anzeigendes Fehlerkennzeichnungs-Signal K erst dann erzeugt wird, wenn dreimal hintereinander dasselbe Signal L am Ausgang 37 der Schwellwerteinrichtung 36 aufgetreten ist.

Bei einem Energieversorgungsnetz mit drei Phasen R, S und T ist jeder Phase eine Anordnung zugeordnet, wie sie in der Figur dargestellt ist. Die Ausgänge der drei Anordnungen entsprechend dem Ausgang 47 sind an Eingänge eines ODER- Gliedes angeschlossen, das an seinem Ausgang dann ein Signal abgibt, wenn mittels einer der drei Anordnungen ein Lichtbogenkurzschluß festgestellt worden ist. Dementsprechend kann dann eine Kurzunterbrechung durch nur vorübergehendes Öffnen der Leistungsschalter im Energieversorgungsnetz vorgenommen werden.

## Patentansprüche

1. Verfahren zum Gewinnen eines Fehlerkennzeichnungs-Signals bei einem Fehler in einem zu überwachenden elektrischen Energieversorgungsnetz mittels einer Neuronalnetz-Anordnung,
- die bei simulierten dauernden und vorübergehenden Fehlern überwacht derart angelernt ist, daß
- sie bei einem dauernden Fehler ein Ausgangssignai mit einem vorgegeben Wert und bei einem vorübergehenden Fehler ein Ausgangssignal mit einem anderen vorgebenen Wert abgibt,
**dadurch gekennzeichnet,** daß
- zur Unterscheidung eines Lichtbogenkurzschlusses von einem metallischen Kurzschluß eine Neuronalnetz-Anordnung verwendet wird, die
- für jede Phase des zu überwachenden Energieversorgungsnetzes ein neuronales Netz (26) aufweist, wobei
- jedes neuronale Netz (26) ein durch Simulation der Spannungen an jeder Phase bei metallischen Kurzschlüssen unter Verwendung von sinusförmigen Spannungen und bei Lichtbogen-Kurzschlüssen unter Verwendung von sinusförmigen Spannungen mit jeweils annähernd rechteckförmiger additiver Spannung überwacht derart angelerntes Verhalten aufweist, daß
- bei einem Lichtbogenkurzschluß das Ausgangssignal (S) mit dem einen vorgegebenen Wert und bei einem metallischen Kurzschluß das Ausgangssignal (S) mit dem anderen vorgegebenen Wert auftritt, und
- gleichzeitig an verschiedene Neuronen (31) der Eingangsschicht (27) jedes neuronalen Netzes (26) aufeinanderfolgend abgetastete, normierte Werte (U_{Rn1}(t) ... U_{Rn20}(t)) der Spannungen (U_{R}(t)) an der jeweils zugeordneten Phase des Energieversorgungsnetzes angelegt werden.

2. Verfahren nach Anspruch 1,
**dadurch gekennzeichnet,** daß
- jeweils ein neuronales Netz (26) verwendet wird, das eine Eingangsschicht (27) mit 20 Neuronen (31), eine erste Zwischenschicht (28) mit 15 Neuronen (32) und eine weitere Zwischenschicht (29) mit 10 Neuronen (33) sowie eine Ausgangsschicht (30) mit einem einzigen Neuron (34) aufweist,
- jeweils während einer der Periodendauer der Spannungen (U_{R}(t)) entsprechenden Zeitdauer zwanzig Abtastwerte (U_{Rn1}(t) bis U_{Rn20}(t)) der Spannungen gewonnen werden und
- jeweils gleichzeitig die jeweils letzten 20 abgetasteten, normierten Werte (U_{Rn1}(t) ... U_{Rn20}(t)) der Spannungen (U_{R}(t)) an der zugeordneten Phase an die Neuronen (31) der Eingangsschicht (27) gelegt werden.

3. Verfahren nach Anspruch 1 oder 2,
**dadurch gekennzeichnet,** daß
- in einer jedem neuronalen Netz (26) nachgeordneten Nachverarbeitungseinrichtung (40) mit mindestens zwei Verzögerungsstufen (45,46) und einem UND-Glied (41) überprüft wird, ob das Fehlerkennzeichnungs-Signal (S) am Ausgang des jeweiligen neuronalen Netzes (26) insgesamt mindestens dreimal aufgetreten ist.

## Claims

1. Process for generating a fault indication signal in the case of a fault in an electric power supply system to be monitored, by means of a neuronal network arrangement
- which, monitored during simulated persisting and transient faults, is trained in such a way that
- it transmits an output signal with one preselected value in the case of a persisting fault and an output signal with another preselected value in the case of a transient fault,
**characterised in that,**
- a neuronal network arrangement is used for discriminating between a short circuit through an arc and a metal short circuit, which neuronal network arrangement
- has a neuronal network (26) for each phase of the power supply system to be monitored, wherein
- each neuronal network (26) has a behaviour learned in a monitored manner by simulation of the voltages at each phase, using sinusoidal voltages in the case of metal short circuits and using sinusoidal voltages with approximately square-wave respective additive voltage in the case of short circuits through an arc, in such a way that
- in the case of a short-circuit through an arc, the output signal (S) with the one preselected value occurs and, in the case of a metal short circuit, the output signal (S) with the other preselected value occurs, and
- at the same time, successively sampled, normalized values (U_{Rn1}(t) ... U_{Rn20}(t)) of the voltages (U_{R}(t)) at the respectively assigned phase of the power supply system are applied to various neurons (31) of the input layer (27) of each neuronal network (26).

2. Process according to claim 1,
**characterised in that**
- there is used a respective neuronal network (26) which has an input layer (27) with 20 neurons (31), a first intermediate layer (28) with 15 neurons (32) and a further intermediate layer (29) with 10 neurons (33), as well as an output layer (30) with a single neuron (34),
- during a respective time period corresponding to the duration of the period of the voltages (U_{R}(t)), twenty sampling values (U_{Rn1}(t) to U_{Rn20}(t)) of the voltages are obtained, and
- at the same time, the respective last 20 sampled, normalized values (U_{Rn1}(t) ... U_{Rn20}(t)) of the voltages (U_{R}(t)) at the associated phase are applied to the neurons (31) of the input layer (27).

3. Process according to claim 1 or 2,
**characterised in that**
- in a re-processing device (40), which is connected downstream to each neuronal network (26) and has at least two time-delay stages (45, 46) and an AND element (41), checking takes place in order to determine whether the fault indication signal (S) has occurred a total of at least three times at the output of the respective neuronal network (26).

## Revendications

1. Procédé d'obtention d'un signal d'indication d'erreur en cas d'erreur dans un réseau d'alimentation en énergie électrique à contrôler, au moyen d'un dispositif de réseaux neuronaux,
- dont on fait l'apprentissage de manière contrôlée en simulant des erreurs persistantes et des erreurs temporaires, de telle sorte que
- le dispositif fournisse en cas d'erreurs persistantes, un signal de sortie ayant une valeur prescrite et, en cas d'erreurs temporaires, un signal de sortie ayant une autre valeur prescrite,
caractérisé en ce que
- pour distinguer un court-circuit par arc électrique d'un court-circuit métallique, on utilise un dispositif de réseaux neuronaux, qui
- comportent, pour chaque phase du réseau d'alimentation en énergie à contrôler, un réseau neuronal (26),
- chaque réseau neuronal (26) ayant un comportement acquis de manière contrôlée par simulation des tensions sur chaque phase, en cas de courts-circuits métalliques en utilisant des tensions sinusoïdales, et, en cas de courts-circuits par arc électrique, en utilisant des tensions sinusoïdales auxquelles est ajoutée une tension approximativement rectangulaire, de telle sorte que
- le signal (S) de sortie ayant la première valeur prescrite apparaisse en cas de court-circuit par arc électrique et le signal (S) de sortie ayant l'autre valeur prescrite apparaisse en cas de court-circuit métallique, et
- on applique simultanément à différents neurones (31) de la couche (27) d'entrée de chaque réseau neuronal (26) des valeurs normées et échantillonnées successivement (U_{Rn1}(t) à U_{Rn20}(t)) des tensions (U_{Rn}(t)) sur la phase respectivement associée du réseau d'alimentation en énergie.

2. Procédé suivant la revendication 1,
caractérisé en ce que
- on utilise un réseau neuronal (26), qui comporte une couche (27) d'entrée à 20 neurones (31), une première couche intermédiaire (28) à 15 neurones (32) et une couche intermédiaire (29) supplémentaire à 10 neurones (33) ainsi qu'une couche de sortie (30) ayant un unique neurone (34),
- on obtient 20 valeurs d'échantillonnage (U_{Rn1}(t) à (U_{Rn20}(t)) des tensions pendant une durée correspondant à la durée d'une période des tensions (U_{R}(t)) et
- on applique simultanément les 20 dernières valeurs échantillonnées et normées (U_{Rn1}(t) à (U_{Rn20}(t)) des tensions (U_{R}(t)) sur la phase associée aux neurones (31) de la couche (27) d'entrée.

3. Procédé suivant la revendication 1 ou 2,
caractérisé en ce que
- on contrôle dans un dispositif (40) de retraitement disposé en aval de chaque réseau neuronal (26) et comportant au moins deux étages (45, 46) à retard et un élément (41) ET, si le signal (S) d'indication d'erreur est apparu à la sortie du réseau neuronal considéré (26) en tout au moins 3 fois.
